# EUROPEAN PATENT APPLICATION

(11) **EP 0 902 475 A2**
(43) Date of publication of application: **17.03.1999**
(21) Application number: 98117441.0
(22) Date of filing: 15.09.1998
(51) Int. Cl.: H01L 23/538, G06K 19/077

(54) **A single-sided package including an integrated circuit semiconductor chip and inductive coil and method therefor**

(30) Priority: 15.09.1997 US 929033
(71) Applicant: MICROCHIP TECHNOLOGY INC., Chandler, AZ 85224-6199 (US)
(72) Inventor: Fernandez, Joseph, Glbert, Arizona 85296 (US); Furey, Leo, Phoenix, Arizona 85048 (US)
(74) Representative: Frohwitter, Bernhard, Dipl.-Ing.

(57) **Abstract**

A single-sided package is disclosed which includes an integrated circuit semiconductor chip and an inductive coil on one surface of the package. The chip is located within the innermost turn of the inductive coil and electrical wire bonds connect terminal pads of the chip to end portions of the inductive coil. A glob of plastic encapsulating material covers and protects the chip and its wire bonds on the substrate surface containing both the inductive coil and the chip.

## Description

### Related Application

This application is related to the copending U.S. Patent Application entitled "COMBINATION INDUCTIVE COIL AND INTEGRATED CIRCUIT SEMICONDUCTOR CHIP IN A SINGLE LEAD FRAME PACKAGE AND METHOD THEREFOR" filed simultaneously herewith in the names of the same inventors of this application and assigned to the same assignee. Accordingly, the contents of this related application is incorporated by reference into this application.

### Background Of The Invention

This invention relates generally to electronic packages and methods therefor and, more particularly, to a single-sided package including an integrated circuit semiconductor chip and inductive coil and method therefor.

### Background Of The Prior Art

In the past, various forms of electronic packages were developed in order to provide electrical circuits that could be used individually as or as part of a system. One early form of these electronic packages was known as a hybrid type package wherein individual semiconductor transistors were mounted on a ceramic substrate along with resistors to form an electrical circuit which could be used with a relatively large printed circuit board because electrically conductive pins connected to the ceramic substrate were inserted into selected via holes in the printed circuit board.

Subsequently, the lead frame technology developed with the result that lead frame packages housing integrated circuit semiconductor chips were inserted into a relatively large printed circuit board by means of the electrically conductive prongs of each lead frame package that were inserted into selected via holes of the printed circuit board. The integrated circuit semiconductor chips often included resistors and/or capacitors fabricated into or as part of the semiconductor chip used to provide the integrated circuit semiconductor chip.

However, as the electronic technology developed, there was a need to create very specialized electronic packages that could operate independently and without a printed circuit board.

### Summary of The Invention

Accordingly, it is an object of this invention to provide an improved electronic package and method therefor.

It is a further object of this invention to provide an improved electronic package and method therefor that includes an integrated circuit semiconductor chip and inductive coil.

It is a still further object of this invention to provide an improved electronic package and method therefor that includes both an integrated circuit semiconductor chip and inductive coil on one side of a package.

It is still another object of this invention to provide an improved electronic package and method therefor that includes both an integrated circuit semiconductor chip and inductive coil on an FR4 (epoxy glass) substrate with the inductive coil formed on the substrate by depositing or forming conductive material in an inductive coil pattern on the substrate and electrically connecting the two end portions of the inductive coil to a pair of corresponding selected terminals of the integrated circuit semiconductor chip to thereby have the inductive coil function as an antenna for the integrated circuit semiconductor chip.

### Brief Description Of The Preferred Embodiments

In accordance with one embodiment of this invention, a single-sided package is provided which comprises, in combination: a single substrate; an inductive coil located on one surface of the single substrate, and an integrated circuit semiconductor chip also located on the one surface of the single substrate and having at least one terminal pad electrically connected to at least one portion of the inductive coil. Preferably, the integrated circuit semiconductor chip has at least two terminal pads. One of the two terminal pads of the integrated circuit semiconductor chip is electrically connected to one end portion of the inductive coil, and the other of the two terminal pads of the integrated circuit semiconductor chip is electrically connected to the other end portion of the inductive coil.

In accordance with another embodiment of this invention, a method of forming a single-sided electronic package is provided which comprises the steps of: providing a single substrate; forming an inductive coil on one surface of the single substrate; and mounting an integrated circuit semiconductor chip on the one surface of the single substrate and having at least one terminal pad electrically connected to at least one portion of the inductive coil.

The foregoing and other objects, features and advantages of this invention will be apparent from the following more particular description of the preferred embodiments of the invention as illustrated in the accompanying drawings.

### Brief Description Of The Drawings

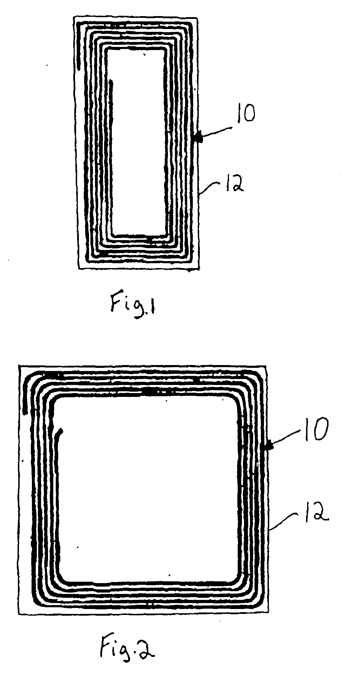

Figure 1 is a top view of the top surface of a rectangular shaped single-sided package of this invention after the formation of an inductive coil metal pattern on the top surface and prior to mounting an integrated circuit semiconductor chip thereon.
Figure 2 is a top view of the top surface of a substantially square shaped single-sided package of this invention after the formation of an inductive coil metal pattern on the top surface and prior to mounting an integrated circuit semiconductor chip thereon.
Figure 3 is a top view similar to Figure 1, but after the mounting of an integrated circuit semiconductor chip on the top surface portion inside the inductive coil and after the formation of the electrical connections between selected terminal pads of the integrated circuit semiconductor chip and end portions of the inductive coil.

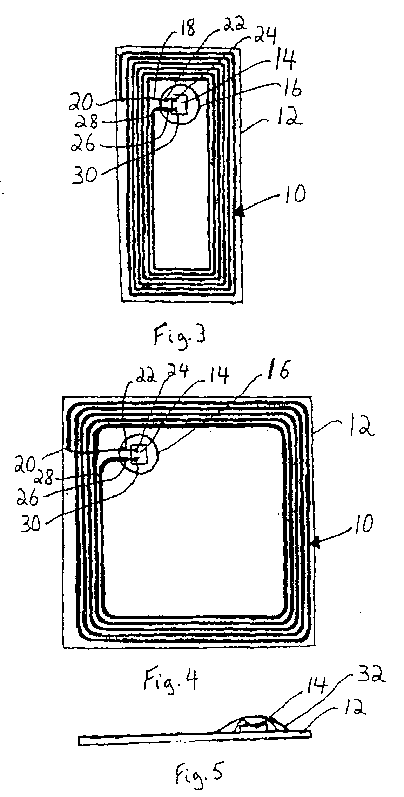

Figure 4 is a top view similar to Figure 3, but after the mounting of an integrated circuit semiconductor chip on the top surface inside the inductive coil and after the formation of the electrical connections between selected terminal pads of the integrated circuit semiconductor chip and end portions of the inductive coil.
Figure 5 is a side elevational view of the single-sided package of either Figure 3 or Figure 4 of this invention with the integrated circuit semiconductor chip and wire bond electrical connections thereto covered with a plastic encapsulated coating covering thereby protecting the integrated circuit semiconductor and its electrical connections.

### Description Of The Specification

Referring to Figure 1, an inductive or Radio Frequency (RF) coil 10 is shown on a single-sided substrate 12. Preferably, the coil 10 which is shown in the embodiment of Figure 1 as containing six full turns is formed on the substrate 12 by, for example, a metal evaporation process through a mask whereby metal is evaporated dawn onto the top surface of the substrate 12 to form the coil 10. Alternatively, if desired, other metal deposition techniques can be used such as R.F. or D.C. sputtering. Also, photolithographic masking and etching techniques can be used to form the desired inductive coil configuration on the substrate 12 if a blanket layer of metal is deposited on the top surface of the substrate 12.

Specifically, in the embodiments of Figures 1 and 2 of this application, a flash gold layer having a thickness of seven microinches of gold is evaporated through a mask to form the coil 12 onto the top surface of the substrate 12. The substrate 12 is preferably made of an epoxy glass board type material that is known as FR4 epoxy glass board which provides an excellent substrate for the deposition and adhesion of the flash gold evaporated layer that forms the inductive coil 10. For production, a single elongated FR4 epoxy glass board is used so that multiple inductive coils can be simultaneously deposited or formed in one operation on separated portions or segments of the elongated FR4 epoxy glass board which can then be cut such as by a diamond blade type saw into separate substrates of the types, for example, shown in Figures 1 and 2. Consequently, in this manner, there is a greater ease in handling and fabricating the substrates with the inductive coils located thereon. The embodiment of Figure 1 depicts the substrate 12 as having a rectangular configuration.

Referring to Figure 2, in this embodiment, the substrate 12 is depicted as having a substantially square shaped configuration and the inductive coil 10 is shown as containing five full turns. The number of full turns can be varied, as desired, to provide a desired electrical inductance for the inductive coil 10.

Referring to Figures 3 and 4, an integrated circuit semiconductor chip 14 is positioned or mounted on the top surface of the substrate 12 substantially centrally disposed within the innermost turn of the inductive coil 10 and preferably, as shown, in a corner portion of this generally central area of the substrate 12. If desired, for chip location purposes and for ease in manufacture, a circular designation 16 is formed on the top surface of the substrate 12 to designate the positioning and location of the chip 14. Preferably, the chip 14 is die mounted onto the top surface of the substrate 12 within the circular designation 16 by means of, for example, a conductive epoxy to die attach the silicon back surface of the chip 14 onto the epoxy glass FR4 board surface After the die attach operation to mount the chip 14 onto the substrate 12 on the same side and within the inductive coil 10, a wire bond electrical connection 18 is formed using wire bonding techniques from end portion 20 of the outer turn of the inductive coil 10 to an electrically conductive spot 22 on the substrate 12 and then to a terminal pad 24 of the chip 14. A separate electrically conductive wire bond 26 is provided to electrically connect end portion 28 of the inner turn of the inductive coil 10 to terminal pad 30 of the chip 14. The chip 14 can be, if desired, a receiver type chip where the inductive coil 10 serves as an RF antenna to receive a signal from a transmitter (not shown) to provide an electrical input to the chip 14. The received electrical input can be stored in a memory portion of the chip 14 for subsequent retrieval. If desired, the chip 14 can be used as a transmitter to transmit, by means of the (antenna) RF coil 10, an output signal stored in the memory of the chip 14. Alternatively, the chip 14 can be used as a combination receiver and transmitter using the RF coil 10 as its antenna. Energy received from an external input signal on the coil 10 serves to operate the receiver when the chip 14 is functioning as a receiver.

Referring to Figure 5, a glob 32 of non-conductive plastic material is deposited only over the chip 14 and the wire bonds connected thereto from the respective end portions of the inductive coil 10 (not shown in Figure 5) to protect the chip 14 and its fragile wire bonds. Epotek and Hysol are companies that manufacture plastic encapsulation material that can be used for this plastic encapsulation glob 32. In this manner, a single-sided package is provided which provides on one side both the the inductive coil 10 and the integrated circuit semiconductor chip 14 with its wire bonds connected thereto protected by the glob 32 of plastic encapsulation.

While the invention has been particularly shown and described with reference to the preferred embodiments thereof, it will be understood by those skilled in the art that the foregoing and other changes in form and details may be made therein without departing from the spirit and scope of the invention.

## Claims

1. A single-sided package comprising, in combination:
a single substrate;
an inductive coil located on one surface of said single substrate; and
an integrated circuit semiconductor chip also located on said one surface of said single substrate and having at least one terminal pad electrically connected to at least one portion of said inductive coil.

2. The single-sided package of Claim 1 wherein said integrated circuit semiconductor chip having at least two terminal pads, one of said two terminal pads of said integrated circuit semiconductor chip being electrically connected to one end portion of said inductive coil, the other of said two terminal pads of said integrated circuit semiconductor chip being electrically connected to the other end portion of said inductive coil.

3. The single-sided package of Claim 2 wherein both of said two terminal pads of said integrated circuit semiconductor chip being located on a top surface of said integrated circuit semiconductor chip, a bottom surface portion of said integrated circuit semiconductor chip being connected to said one surface of said single substrate.

4. The single-sided package of Claim 3 wherein said single substrate is an FR4 epoxy glass substrate.

5. The single-sided package of Claim 4 wherein said inductive coil comprising having a coil configuration.

6. The single-sided package of Claim 1 wherein said integrated circuit semiconductor chip is a transmitter, said inductive coil is a transmitting antenna for said transmitter.

7. The single-sided package of Claim 1 wherein said integrated circuit semiconductor chip is a receiver, said inductive coil is a receiving antenna for said receiver.

8. The single-sided package of Claim 1 wherein said integrated circuit semiconductor chip being located on said one surface of said single substrate inside an innermost turn of said inductive coil.

9. The single-sided package of Claim 8 wherein an inner end portion of said inductive coil being located adjacent one side of said integrated circuit semiconductor chip.

10. The single-sided package of Claim 1, wherein said integrated circuit semiconductor chip being located on and attached to a portion of said one surface of said single substrate, said single substrate having a substantially rectangular configuration, and a plastic encapsulation layer located on and covering only said integrated circuit semiconductor chip and wire bonds connected thereto.

11. A method of forming a single-sided electronic package comprising the steps of:
providing a single substrate;
forming an inductive coil on one surface of said single substrate; and
mounting an integrated circuit semiconductor chip on said one surface of said single substrate and having at least one terminal pad electrically connected to at least one portion of said inductive coil.

12. The method of Claim 11 wherein said integrated circuit semiconductor chip having at least two terminal pads, one of said two terminal pads of said integrated circuit semiconductor chip being electrically connected to one end portion of said inductive coil, the other of said two terminal pads of said integrated circuit semiconductor chip being electrically connected to the other end portion of said inductive coil.

13. The method of Claim 12 wherein both of said two terminal pads of said integrated circuit semiconductor chip being located on a top surface of said integrated circuit semiconductor chip, a bottom surface portion of said integrated circuit semiconductor chip being connected to said one surface of said single substrate.

14. The method of Claim 13 wherein said single substrate is an FR4 epoxy glass substrate.

15. The method of Claim 14 wherein said inductive coil comprising gold having a coil configuration.

16. The method of Claim 11 wherein said integrated circuit semiconductor chip is a transmitter, said inductive coil is a transmitting antenna for said transmitter.

17. The method of Claim 1 wherein said integrated circuit semiconductor chip is a receiver, said inductive coil is a receiving antenna for said receiver.

18. The method of Claim 11 wherein said integrated circuit semiconductor chip being located on said one surface of said single substrate inside an innermost turn of said inductive coil.

19. The method of Claim 18 wherein an inner end portion of said inductive coil being located adjacent one side of said integrated circuit semiconductor chip.

20. The method of Claim 11 wherein said integrated circuit semiconductor chip being located on and attached to a portion of said one surface of said single substrate, said single substrate having a substantially rectangular configuration and a plastic encapsulation layer located on and covering only said integrated circuit semiconductor chip and wire bonds connected thereto.
